# EUROPEAN PATENT SPECIFICATION

(11) **EP 4 179 132 B1**
(45) Date of publication and mention of the grant of the patent: **25.09.2024**
(21) Application number: 21737093.1
(22) Date of filing: 30.06.2021
(51) Int. Cl.: C25D 3/38, C25D 7/12

(54) **COMPOSITION FOR COPPER ELECTROPLATING ON A COBALT SEED**
ZUSAMMENSETZUNG ZUR KUPFERGALVANISIERUNG AUF EINEM KOBALT-SEED
COMPOSITION POUR ÉLECTRODÉPOSITION DE CUIVRE SUR UN GERME DE COBALT

(30) Priority: 13.07.2020 US 202063050905 P; 20.07.2020 EP 20186697
(43) Date of publication of application: 17.05.2023
(73) Proprietor: BASF SE, 67056 Ludwigshafen am Rhein (DE)
(72) Inventor: EMNET, Charlotte, 67056 Ludwigshafen (DE); STREMPEL, Verena, 67056 Ludwigshafen (DE); HENDERSON, Lucas Benjamin, 67056 Ludwigshafen (DE); FLUEGEL, Alexander, 67056 Ludwigshafen (DE); BRAENDLE, Robert, Hillsboro, New Jersey 97124 (US); KITAYAPORN, Sathana, Hillsboro, New Jersey 97124 (US); ENGELHARDT, Nadine, 67056 Ludwigshafen (DE)
(74) Representative: BASF IP Association
(86) International application number: PCT/EP2021/068001
(87) International publication number: WO 2022/012932

(56) References cited:
- WO-A1-2018/073011
- WO-A1-2019/199614
- US-A1- 2019 390 356
- PIEGARI A ET AL: "Thin film thickness measurement: A comparison of various techniques", THIN SOLID FILMS, ELSEVIER, AMSTERDAM, NL, vol. 124, no. 3-4, 22 February 1985 (1985-02-22), pages 249 - 257, XP024593137, ISSN: 0040-6090, [retrieved on 19850222], DOI: 10.1016/0040-6090(85)90273-1

## Description

The present invention relates to a composition for copper electroplating comprising copper ions and a seed protecting and nucleation agent.

### Background of the Invention

Formation of metal wiring interconnects in integrated circuits (ICs) can be achieved using a damascene or dual damascene process. Typically, trenches or holes are etched into dielectric material, such as silicon dioxide, located on a substrate. The holes or trenches may be lined with one or more liner layers and barrier layers. Then a thin layer of copper may be deposited in the holes or trenches that can act as a copper seed layer. Thereafter, the holes or trenches may be filled with copper.

Conventional copper deposition typically occurs in two steps. First, a copper seed layer is deposited on the substrate using a PVD process. Second, copper is electroplated on the seed layer to fill the holes or trenches.

Techniques have been developed that avoid depositing a copper seed layer using PVD by directly electroplating copper on barrier or liner layers. However, challenges exist in directly electroplating copper on barrier or liner layers.

WO 2019/199614 A1 discloses a void-free bottom-up fill of copper into interconnect features comprising a non-copper liner that show a higher resistivity than copper, such as cobalt or ruthenium. The electroplating solution includes a low copper concentration, high pH, organic additives, and bromide ions as a copper complexing agent.

One class of additives are the so-called suppressors, suppressing agents or sometimes simply surfactants. Suppressors are used to provide a substantially bottom-up filling of small features like vias or trenches. The smaller the features are the more sophisticated the additives have to be to avoid voids and seams. In literature, a variety of different suppressing compounds have been described. The mostly used class of suppressors are polyether compounds like polyglycols or polyalkylene oxides like ethylene oxide propylene oxide copolymers.

WO 2006/053242 A1 discloses amine-based polyoxyalkylene suppressors. The amine may be methylamine, ethylamine, propylamine, ethylendiamine, diethylenetriamine, diaminopropane, diethyleneglykol diamine or triethylenglycol diamine. The copolymers may have block, alternating or random structure. Compounds provided by BASF under the trademark TETRONIC ^{®}, all of those being EO/PO block copolymers of ethylene diamine, and having a molecular mass of up to 5500 g/mol are described to be preferred. The block copolymers of EO and PO are used in the examples .

WO 2010/115717, WO 2011/012475, and WO 2018/114985 disclose compositions comprising suppressors based on particular amine started polyalkoxyalkylene copolymers for copper electrodeposition on copper seeds.

With further decreasing aperture size of the features like vias or trenches to dimensions of below 5 nanometers and even below 3 nanometers, respectively, the filling of the interconnects with copper becomes especially challenging, also since the copper seed deposition prior to the copper electrodeposition might exhibit inhomogeneity and nonconformity and thus further decreases the aperture sizes particularly at the top of the apertures. The smaller the size of the feature becomes the more difficult it is to get a continuous seed on the side walls of the feature without significant seed overhang.

To avoid these difficulties associated with a non-copper liner layer such as cobalt or ruthenium is proposed in WO 2019/199614 A1 an electroplating solution for plating copper on a non-copper liner layer including a low copper concentration, high pH, organic additives, and bromide ions as a copper complexing agent.

The consequence of using bromide is that the electrochemical properties of the additives change significantly which makes their selection more difficult than for composition used for plating without bromide. Electrochemical investigations of polyalkylene copolymer suppressor type reveal that the properties of the suppressing agents are significantly changed since the suppressing effect is increased in the presence of bromide compared to the case without bromide. The presence of bromide will likely influence the adsorption/desorption behavior of the suppressor.

Furthermore, cobalt is a less noble metal compared to copper and quickly corrodes in the presence of an acid and oxygen, particularly if copper is present, too. On the other hand, alkaline electroplating bath that would show less cobalt corrosion provide bad filling and dirty copper fillings due to the use of complexings agents that are required to keep copper in solution.

It is therefore an object of the present invention to provide a copper electroplating composition that is capable of providing a substantially voidless and seamless filling of features on the nanometer scale comprising a cobalt seed with a copper electroplating bath, particularly an acidic copper electroplating bath.

It is a further object of the present invention to provide an electroplating bath that is capable of providing a filling of recessed features having a cobalt seed layer with copper and providing a low or at least reduced corrosion of the cobalt seed layer. It is a further object of the present invention to provide an additive that provides bottom-up fill capability, particularly into features having an aperture size of 10, particularly 5 nm and below. Furthermore, it is important to provide additives that are compatible with electroplating compositions that comprise bromide ions.

### Summary of the Invention

Surprisingly, it has now been found, that the particular polyamine-based additives defined herein show good bottom-up filling as well as a good corrosion inhibition of the cobalt seed layer.

Therefore, the present invention provides an acidic aqueous composition for copper electroplating comprising
(a) copper ions;
(b) bromide ions; and
(c) at least one additive of formula S1 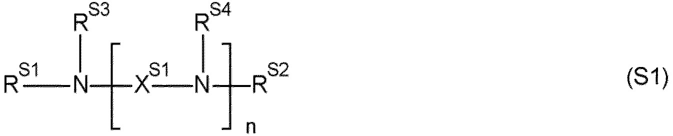 wherein
   - X^{S1}: is selected from a linear, branched or cyclic C₁-C₁₂ alkanediyl, which may be substituted or unsubstituted, and which may optionally be interrupted by O, S or NR^{S40};
   - R^{S1}: is a monovalent
   (a) poly(oxy(C₃ to C₆ )alkylene)-block-poly(oxyethylene) group which is bound to the N-atom by the poly(oxy(C₃ to C₆ )alkylene part, or
   (b) a poly(oxyethylene)-block-poly(oxy(C₃ to C₆ )alkylene)-block-poly(oxyethylene),
   which both have a poly(oxyethylene) content of from 5 to 30 % by weight;
   - R^{S2}, R^{S3}, R^{S4}: (a) are selected from H, R^{S1}, R^{S40}, or
   (b) R^{S3} and an adjacent group R^{S4} or, if n>2, two adjacent groups R^{S4} may together form a divalent group X^{S3};
   - R^{S40}: is selected from (a) linear or branched C₁-C₂₀ alkyl, which may optionally be substituted by hydroxy, alkoxy or alkoxycarbonyl, and (b) linear or branched C₁-C₂₀ alkenyl, which may optionally be substituted by hydroxyl, alkoxy or alkoxycarbonyl;
   - X^{S3}: is selected from a linear, branched or cyclic C₁-C₁₂ alkanediyl, which may be substituted or unsubstituted, and which may optionally be interrupted by O, S or NR^{S40}; and
   - n: is an integer of from 1 to 6.

The invention further relates to the use of a copper electroplating bath comprising a composition as described herein for depositing copper on substrates comprising recessed features having an aperture size of 30 nanometers or less, which features comprise a cobalt seed.

The invention further relates to a process for depositing a copper layer comprising the steps
(a) providing a substrate comprising a nanometer-sized recessed feature, which feature comprises a cobalt seed layer;
(b) contacting the composition as described herein with the substrate, and
(c) applying a current to the substrate for a time sufficient to deposit a metal layer onto the cobalt seed layer and to fill the nanometer sized feature.

The additive provides a good nucleation of copper on the cobalt seed layer. It allows electroplating over thin seed layers and fast bottom-up fill in both large and small features without causing voids or seams. Furthermore, the additive effectively suppresses corrosion of the cobalt seed layer.

The suppressing agents according to the present invention are particularly useful for filling of small recessed features, particularly those having aperture sizes of 20 nm or below, particularly 10 nm or below, most particularly 5 nm or below.

### Brief description of the Figures

- Fig. 1: shows a SEM image of a patterned wafer substrate that was used for copper electroplating in the examples;
- Fig. 2: shows a SEM image of partially filled trenches after copper electroplating according to example B1a;
- Fig. 3: shows a SEM image of fully filled trenches after copper electroplating according to example B1b;
- Fig. 4: shows a SEM image of partially filled trenches after copper electroplating according to example B1c;
- Fig. 5: shows a SEM image of fully filled trenches after copper electroplating according to example B1d;
- Fig. 6: shows a SEM image of partially filled trenches after copper electroplating according to example B2a;
- Fig. 7: shows a SEM image of fully filled trenches after copper electroplating according to example B2b;
- Fig. 8: shows a SEM image of fully filled trenches after copper electroplating according to example B2c;
- Fig. 9: shows a SEM image of partially filled trenches after copper electroplating according to example B3a;
- Fig. 10: shows a SEM image of fully filled trenches after copper electroplating according to example B3b;
- Fig. 11: shows a SEM image of partially filled trenches after copper electroplating according to example B4a;
- Fig. 12: shows a SEM image of fully filled trenches after copper electroplating according to example B4b;
- Fig. 13: shows a SEM image of partially filled trenches after copper electroplating according to example B5a;
- Fig. 14: shows a SEM image of fully filled trenches after copper electroplating according to example B5b;

### Detailed Description of the Invention

### Additives according to the invention

It was found that the electroplating compositions according to the invention comprising bromide ions and at least one additive as described below show extraordinary performance in feature filling that are nanometer sized and have a cobalt liner or seed. The additive acts as a suppressing agent as well as cobalt corrosion inhibitor. The additive is also referred to herein as "suppressing agent".

Besides the electrolyte the aqueous composition according to the present invention comprises at least one additive of formula S1

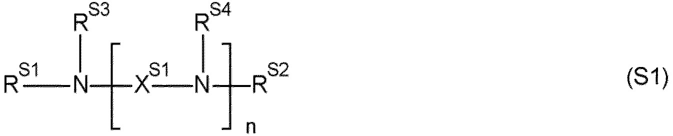

Generally, the suppressing agent consists of a polyamine starter comprising one or more polyoxyalkylene side arms.

X^{S1} is a spacer group within the polyamine starter. It may be a linear or branched C₁-C₁₂ alkanediyl, which may be substituted or unsubstituted, preferably unsubstituted. Such alkanediyl spacer may optionally be interrupted by O, S or NR^{S40}. In a first preferred embodiment X^{S1} is C₁-C₆ alkanediyl, more preferably C₁-C₄ alkanediyl, most preferably methanediyl, ethanediyl or propanediyl. In a second preferred embodiment heteroatoms are present and X^{S1} may be -(CH₂)_{q}-[Q-(CH₂)ᵣ]ₛ-, wherein Q is selected from O, S or NR⁴⁰, q and r are integers from 1 to 6, s is an integer from 1 to 4 and q + r s is the total number of C atoms in X^{S1}. Particularly preferred is a spacer with Q=O and q=r = 1 or 2, and s=1. Useful substituents may be hydroxy, alkoxy, and alkoxycarbonyl.

Group R^{S1} (also referred to herein as "polyoxyalkylene" group) comprises a poly(oxy(C₃ to C₆ )alkylene) and a poly(oxyethylene) parts arranged in block order. The poly(oxy(C₃ to C₆ )alkylene) is also referred to herein as AO and poly(oxyethylene) as EO.

In a first embodiment group R^{S1} may be a monovalent poly(oxy(C₃ to C₆ )alkylene)-block-poly(oxyethylene) group (-AO-EO). This bi-block oxyalkylene group is bound to the N-atom by the more hydrophobic poly(oxy(C₃ to C₆ )alkylene part. In other words: The poly(oxyethylene) part terminates the group R^{S1}.

In an alternative embodiment group R^{S1} may be a monovalent poly(oxyethylene)-block-poly(oxy(C₃ to C₆ )alkylene)-block-poly(oxyethylene) group (-EO-AO-EO). Also in this tri-block oxyalkylene group the EO part terminates the group R^{S1}. It is preferred that at least 50 %, more preferably 75 % of the EO is located at the terminating end of group R^{S1}.

The polyoxyalkylene group R^{S1} has a poly(oxyethylene) content of from 5 to 30 % by weight, preferably from 7 to 29 % by weight, even more preferably from 8 to 28 % by weight.

The respective polyoxyalkylene block copolymers may be prepared from the respective alkylene oxides.

Preferably the at least one C₃ to C₆ polyoxyalkylene block in R^{S1} is selected from polyoxypropylene (prepared from propylene oxide), and polyoxybutylene (prepared from butylene oxide).

R^{S2}, R^{S3}, R^{S4} is either selected from H, R^{S1}, R^{S40}; or R^{S3} and an adjacent group R^{S4} or, if n>2, two adjacent groups R^{S4} may together form a divalent group X^{S3}. In the latter case X^{S3} may be selected from a linear or branched C₁-C₁₂ alkanediyl, which may optionally be interrupted by O, S or NR^{S40}. R^{S40} may be (a) linear or branched C₁-C₂₀ alkyl, which may optionally be substituted by hydroxyl, alkoxy or alkoxycarbonyl, and (b) linear or branched C₁-C₂₀ alkenyl, which may optionally be substituted by hydroxyl, alkoxy or alkoxycarbonyl. Preferably RS40 is a C₁ to C₆ alkyl or a C₁ to C₁₂ hydroxyalkyl. Preferably X^{S3} is selected from a linear or branched C₁-C₆ alkanediyl, more preferably from a C₁-C₄ alkanediyl, most preferably from methyl or ethyl or propyl. In this case X^{S1} is preferably selected so as to form a 5 or 6 membered ring system.

In a preferred embodiment, all groups R^{S2}, R^{S3}, R^{S4} are a polyoxyalkylene group R^{S1} as defined above.

Generally, n may be an integer of from 1 to 6. Preferably n is an integer from 1 to 4, most preferably n is 1 or 2.

Generally, the molecular mass M_{w} of the suppressing agent may be from about 300 to about 25 000 g/mol, preferably 500 to 15000 g/mol. In one embodiment the molecular mass M_{w} of the suppressing agent is from about 500 to about 8000 g/mol, preferably from about 1000 to about 6000 g/mol, most preferably from about 1000 to about 3500 g/mol. In another preferred embodiment the molecular mass M_{w} of the suppressing agent is from about 5000 to about 20 000 g/mol, in particular from about 6000 to about 15 000 g/mol.

A first preferred embodiment is an additive of formula (S2a) 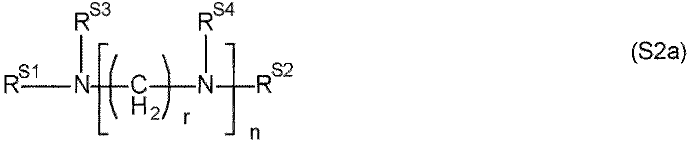 wherein
- R^{S1}: has the prescribed meanings;
- R^{S2}, R^{S3} and R^{S4}: are selected from R^{S1} or R^{S40}, preferably R^{S1};
- r: is an integer from 1 to 8, preferably 2 to 6, most preferably 2, 3 or 4;
- R^{S40}: has the prescribed meanings and is preferably C₁ to C₆ alkyl or C₁ to C₁₂ hydroxyalkyl; and
- n: is 1, 2, or 3.

A second preferred embodiment is an additive of formula (S2b) 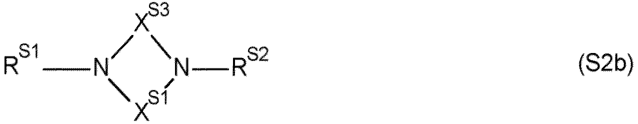
- R^{S1}: has the prescribed meanings;
- R^{S2}: is selected from R^{S1} or R^{S40}, preferably R^{S1};
- R^{S40}: has the prescribed meanings and is preferably C₁ to C₆ alkyl or C₁ to C₁₂ hydroxyalkyl; and
- X^{S1}, X^{S3}: are independently a C₁ to C₃ alkanediyl, preferably X^{S1} and X^{S3} are both ethanediyl or either X^{S1} or X^{S3} is methanediyl and the other of X^{S1} and X^{S3} is propanediyl.

Such compounds may be prepared by starting from cyclic amines, such as but not limited to piperazin, methylpiperazin, ethylpiperazin, propylpiperazin, butylpiperazin, and the like.

A third preferred embodiment is an additive of formula (S2c) 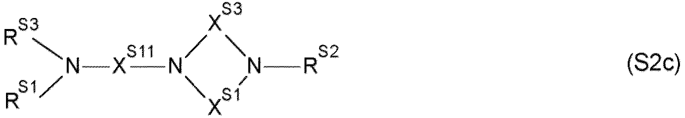 wherein
- R^{S1}: has the prescribed meanings;
- R^{S2} and R^{S3}: are selected from R^{S1} or R^{S40}, preferably R^{S1};
- R^{S40}: has the prescribed meanings and is preferably C₁ to C₆ alkyl or C₁ to C₁₂ hydroxyalkyl; and
- X^{S1}, X^{S11}, X^{S3}: are independently a C₁ to C₃ alkanediyl, preferably X^{S1} and X^{S3} are both ethanediyl or either X^{S1} or X^{S3} is methanediyl and the other of X^{S1} and X^{S3} is propanediyl.

A fourth preferred embodiment is an additive of formula (S2d) 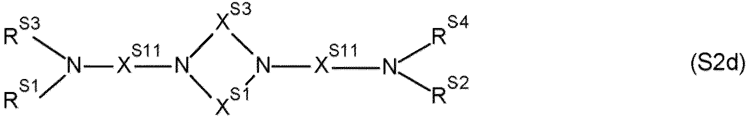 wherein
- R^{S1}: has the prescribed meanings;
- R^{S2}, R^{S3} and R^{S4}: are selected from R^{S1} or R^{S40}, preferably R^{S1};
- R^{S40}: has the prescribed meanings and is preferably C₁ to C₆ alkyl or C₁ to C₁₂ hydroxyalkyl; and
- X^{S1}, X^{S11}, X^{S3}: are independently a C₁ to C₃ alkanediyl, preferably X^{S1} and X^{S3} are both ethanediyl or either X^{S1} or X^{S3} is methanediyl and the other of X^{S1} and X^{S3} is propanediyl.

Such compounds of embodiments three and four may be prepared by starting from aminoalkylated cyclic amines, such as but not limited to bisaminoethyl piperazin, bisaminopropyl piperazin, bisaminobutyl piperazin, and the like.

Further useful polyamine starters are described in WO 2018/073011, which is incorporated herein by reference.

### Plating Bath

A wide variety of metal plating baths may be used with the present invention. Metal electroplating baths typically contain a copper ion source, bromide ions, an electrolyte, the suppressing agent, and optionally further additives such as but not limited to accelerators, levelers, surfactants.

The plating baths are typically aqueous. The term "aqueous" means that the plating bath is water based. The water may be present in a wide range of amounts. Any type of water may be used, such as distilled, deionized or tap. Preferably the plating bath is a solution of the compounds described herein in water. Preferably the water is electronic grade deionized water. Other solvents besides water may be present in minor amounts but preferably water is the only solvent.

The suppressing agents of the invention are typically used in an amount of about 0.1 ppm to about 1000 ppm, based on the total weight of the plating bath. Particularly suitable amounts of suppressor useful in the present invention are 1 to 700 ppm, and more particularly 10 to 500 ppm.

The metal ion source may be any compound capable of releasing copper ions to be deposited in the electroplating bath in sufficient amount, i.e. is at least partially soluble in the electroplating bath. In a preferred embodiment, no further metals besides copper are present in the electroplating bath. In other preferred embodiment the metal comprises copper and comprise tin in amount of below 0.1 g/l, preferably below 0.01 g/l, most preferably no tin.

It is preferred that the copper ion source is soluble in the plating bath to release 100 % of the metal ions. Suitable copper ion sources are metal salts and include, but are not limited to, metal sulfates, metal halides, metal acetates, metal nitrates, metal fluoroborates, metal alkylsulfonates, metal arylsulfonates, metal sulfamates, metal gluconates and the like. It is preferred that the metal is copper. It is further preferred that the source of copper ions is copper sulfate, copper chloride, copper acetate, copper citrate, copper nitrate, copper fluoroborate, copper methane sulfonate, copper phenyl sulfonate and copper p-toluene sulfonate. Copper sulfate pentahydrate and copper methane sulfonate are particularly preferred. Such metal salts are generally commercially available and may be used without further purification.

The copper ion source may be used in the present invention in any amount that provides sufficient metal ions for electroplating on a substrate.

Copper is typically present in an amount in the range of from about 0.2 to about 300 g/l of the plating solution. Generally, the suppressor is useful in low copper, medium copper and high copper baths. Low copper means a copper concentration from about 0.3 to about 20 g/l.

Bromide ions are typically present in an amount of from 0.25 to 250 ppm, preferably from 5 to 100 ppm, most preferably from 10 to 80 ppm as described in US 8 268 155 B1 or WO 2019/199614 A1.

Also mixtures of metal salts may be electroplated according to the present invention. Thus, alloys, such as copper-tin having up to about 2 percent by weight tin, may be advantageously plated according to the present invention. The amounts of each of the metal salts in such mixtures depend upon the particular alloy to be plated and is well known to those skilled in the art.

In general, besides the copper ions, bromide ions and at least one of the suppressing agents according to the present invention the present copper electroplating compositions preferably include an electrolyte, one or more sources of metal ions, optionally further halide ions, particularly chloride ions, and optionally other additives like accelerators and/or levelers.

The electroplating baths of the present invention may be prepared by combining the components in any order. It is preferred that the inorganic components such as metal salts, water, electrolyte and optional halide ion source, are first added to the bath vessel followed by the organic components such as leveling agents, accelerators, suppressors, surfactants and the like.

Typically, the plating baths of the present invention may be used at any temperature from 10 to 65 °C or higher. It is preferred that the temperature of the plating baths is from 10 to 35 °C and more preferably from 15 to 30 °C.

Suitable acidic electrolytes include such as, but not limited to, sulfuric acid, acetic acid, fluoroboric acid, alkylsulfonic acids such as methanesulfonic acid, ethanesulfonic acid, propanesulfonic acid and trifluoromethane sulfonic acid, arylsulfonic acids such as phenyl sulfonic acid and toluenesulfonic acid, sulfamic acid, hydrochloric acid, phosphoric acid, and the like. In a particular embodiment the electrolyte does not comprise pyrophosphoric acid. The acids are typically present in an amount in the range of from about 0.1 to about 300 g/l. The plating bath may be a high, a medium or a low acid bath. Low acid baths usually comprise one or more acids in a concentration below 15 g/l or even below 10 g/l or 5 g/l. As used herein, "acidic" means that the pH of the plating bath is below 7, preferably below 5. More preferably the pH of the acidic plating bath is below 4, even more preferably below 3, most preferably below 2.

Such electrolytes may optionally contain a source of further halide ions, such as chloride ions as in copper chloride, or hydrochloric acid. A wide range of chloride ion concentrations may be used in the present invention such as from about 0 to about 500 ppm. Typically, the chloride ion concentration is in the range of from about 1 to about 100 ppm, preferably from about 10 ppm to about 100 ppm, most preferably from 20 to 80 ppm, based on the plating bath. It is preferred that the electrolyte is sulfuric acid or methanesulfonic acid, and preferably a mixture of sulfuric acid or methanesulfonic acid and a source of chloride ions. The acids and sources of halide ions useful in the present invention are generally commercially available and may be used without further purification.

In a particular embodiment the suppressors of this invention may be used in low copper electrolyte compositions typically containing about below 20 g/l copper ions, in combination with typically about 0.1-15 g/I acid like sulfuric acid and with bromide ions typically in the range of about 10-400 ppm by weight, preferably in combination with chloride ions.

### Other additives

The electroplating baths according to the present invention may include one or more optional additives. Such optional additives include, but are not limited to, accelerators, other suppressors, levelers, surfactants and the like.

Any accelerators may be advantageously used in the plating baths according to the present invention. Accelerators useful in the present invention include, but are not limited to, compounds comprising one or more sulphur atom and a sulfonic/phosphonic acid or their salts. Preferably the composition further comprises at least one accelerating agent.

Preferred accelerators have the general structure MO₃X-R²¹-(S)ₙ-R²², with:
- M is a hydrogen or an alkali metal (preferably Na or K)
- X is P or S
- n = 1 to 6
- R²¹ is selected from C₁-C₈ alkyl group or heteroalkyl group, an aryl group or a heteroaromatic group. Heteroalkyl groups will have one or more heteroatom (N, S, O) and 1-12 carbons. Carbocyclic aryl groups are typical aryl groups, such as phenyl, naphtyl. Heteroaromatic groups are also suitable aryl groups and contain one or more N,O or S atom and 1-3 separate or fused rings.
- R²² is selected from H or (-S-R²¹'XO₃M), with R²¹' being identical or different from R²¹.

More specifically, useful accelerators include those of the following formulae:

MO₃S-R²¹-SH

MO₃S-R²¹-S-S-R²¹'-SO₃M

MO₃S-Ar-S-S-Ar-SO₃M

with R²¹ is as defined above and Ar is Aryl.

Particularly preferred accelerating agents are:
- SPS: bis-(3-sulfopropyl)-disulfide disodium salt
- MPS: 3-mercapto-1-propansulfonic acid, sodium salt

Other examples of accelerators, used alone or in mixture, include, but are not limited to: MES (2-Mercaptoethanesulfonic acid, sodium salt); DPS (N,N-dimethyldithiocarbamic acid (3-sulfopropylester), sodium salt); UPS (3-[(amino-iminomethyl)-thio]-1-propylsulfonic acid); ZPS (3-(2-benzthiazolylthio)-1-propanesulfonic acid, sodium salt); 3-mercapto-propylsulfonicacid-(3-sulfopropyl)ester; methyl-(ω̅-sulphopropyl)-disulfide, disodium salt; methyl-(ω̅-sulphopropyl)-trisulfide, disodium salt.

Such accelerators are typically used in an amount of about 0.1 ppm to about 3000 ppm, based on the total weight of the plating bath. Particularly suitable amounts of accelerator useful in the present invention are 1 to 500 ppm, and more particularly 2 to 100 ppm.

Any additional suppressor may be advantageously used in the present invention. Suppressors useful in the present invention include, but are not limited to, polymeric materials, particularly those having heteroatom substitution, and more particularly oxygen substitution. It is preferred that the suppressor is a polyalkyleneoxide. Suitable suppressors include polyethylene glycol copolymers, particularly polyethylene glycol polypropylene glycol copolymers. The arrangement of ethylene oxide and propylene oxide of suitable suppressors may be block, alternating, gradient, or random. The polyalkylene glycol may comprise further alkylene oxide building blocks such as butylene oxide. Preferably, the average molecular weight of suitable suppressors exceeds about 2000 g/mol. The starting molecules of suitable polyalkylene glycol may be alkyl alcohols such as methanol, ethanol, propanol, n-butanol and the like, aryl alcohols such as phenols and bisphenols, alkaryl alcohols such as benzyl alcohol, polyol starters such as glycol, glycerin, trimethylol propane, pentaerythritol, sorbitol, carbohydrates such as saccharose, and the like, amines and oligoamines such as alkyl amines, aryl amines such as aniline, triethanol amine, ethylene diamine, and the like, amides, lactams, heterocyclic amines such as imidazol and carboxylic acids. Optionally, polyalkylene glycol suppressors may be functionalized by ionic groups such as sulfate, sulfonate, ammonium, and the like.

If further suppressors are used, they are typically present in an amount in the range of from about 1 to about 10,000 ppm based on the weight of the bath, and preferably from about 5 to about 10,000 ppm. Preferably no further suppressing agent than the suppressing agent according to the invention is present in the plating bath.

Leveling agents can advantageously be used in the metal plating baths according to the present invention. The terms "leveling agent" and "leveler" are used herein synonymously. Preferably the composition further comprises at least one leveling agent.

Suitable leveling agents include, but are not limited to, one or more of polyethylene imine and derivatives thereof, quaternized polyethylene imine, polyglycine, poly(allylamine), polyaniline, polyurea, polyacrylamide, poly(melamine-co-formaldehyde), reaction products of amines with epichlorohydrin, reaction products of an amine, epichlorohydrin, and polyalkylene oxide, reaction products of an amine with a polyepoxide, polyvinylpyridine, polyvinyl imidazole as described e.g. in WO 2011/151785 A1, polyvinylpyrrolidone, polyaminoamides as described e.g. in WO 2011/064154 A2 and WO 2014/072885 A2, WO 2019/043146 A1, or copolymers thereof, nigrosines, pentamethyl-para-rosaniline hydrohalide, hexamethylpararosaniline hydrohalide, di- or trialkanolamines and their derivatives as described in WO 2010/069810, and biguanides as described in WO 2012/085811 A1. Furthermore, a compound containing a functional group of the formula N-R-S may be used as a leveling agents, where R is a substituted alkyl, unsubstituted alkyl, substituted aryl or unsubstituted aryl. Typically, the alkyl groups are (C₁-C₆)alkyl and preferably (C₁-C₄)alkyl. In general, the aryl groups include (C₆-C₂₀)aryl, preferably (C₆-C₁₀)aryl. Such aryl groups may further include heteroatoms, such as sulfur, nitrogen and oxygen. It is preferred that the aryl group is phenyl or napthyl. The compounds containing a functional group of the formula N-R-S are generally known, are generally commercially available and may be used without further purification. In such compounds containing the N-R-S functional group, the sulfur ("S") and/or the nitrogen ("N") may be attached to such compounds with single or double bonds. When the sulfur is attached to such compounds with a single bond, the sulfur will have another substituent group, such as but not limited to hydrogen, (C₁-C₁₂)alkyl, (C₂-C₁₂)alkenyl, (C₆-C₂₀)aryl, (C₁-C₁₂)alkylthio, (C₂-C₁₂)alkenylthio, (C₆-C₂₀)arylthio and the like. Likewise, the nitrogen will have one or more substituent groups, such as but not limited to hydrogen, (C₁-C₁₂)alkyl, (C₂-C₁₂)alkenyl, (C₇-C₁₀)aryl, and the like. The N-R-S functional group may be acyclic or cyclic. Compounds containing cyclic N-R-S functional groups include those having either the nitrogen or the sulfur or both the nitrogen and the sulfur within the ring system.

In general, the total amount of leveling agents in the electroplating bath is from 0.5 ppm to 10 000 ppm based on the total weight of the plating bath. The leveling agents are typically used in a total amount of from about 0.1 ppm to about 1 000 ppm based on the total weight of the plating bath and more typically from 1 to 100 ppm, although greater or lesser amounts may be used.

A large variety of further additives may typically be used in the bath to provide desired surface finishes for the Cu plated metal. Usually more than one additive is used with each additive forming a desired function. Advantageously, the electroplating baths may contain one or more of accelerators, levelers, sources of halide ions, grain refiners and mixtures thereof. Most preferably the electroplating bath contains both, an accelerator and a leveler in addition to the suppressor according to the present invention. Other additives may also be suitably used in the present electroplating baths.

### Process

According to one embodiment of the present invention a copper electroplating bath comprising a composition as described herein may be used for depositing copper on substrates comprising recessed features having an aperture size of 30 nanometers or less, which features comprise a cobalt seed.

A further embodiment of the present invention is a process for depositing a copper layer comprising the steps
(a) providing a substrate comprising a nanometer-sized recessed feature, which feature comprises a cobalt seed layer;
(b) contacting the composition as described herein with the substrate, and
(c) applying a current to the substrate for a time sufficient to deposit a metal layer onto the cobalt seed layer and to fill the nanometer sized feature.

The present invention is useful for depositing a copper layer on a variety of cobalt seeded substrates, particularly those having nanometer and variously sized apertures. For example, the present invention is particularly suitable for depositing copper on integrated circuit substrates, such as semiconductor devices, with small diameter vias, trenches or other apertures that are provided with a cobalt seed layer. In one embodiment, semiconductor devices are plated according to the present invention. Such semiconductor devices include, but are not limited to, wafers used in the manufacture of integrated circuits.

Usually, the cobalt seed layer has a thickness of 40 nm to 1.5 nm, preferably of 2 to 10 nm.

Preferably, the static corrosion of the cobalt seed layer in the electroplating composition is 10 nm/min or below, preferably 5 nm/min or below, most preferably 3 nm/min or below. As used herein, "static corrosion" means that the electroplating composition is brought into contact with the substrate without applying any electric potential or mechanic abrasion.

Most preferably the submicrometer-sized features have an (effective) aperture size from 1 to 30 nanometers and/or an aspect ratio of 4 or more. More preferably the features have an aperture size of 25 nanometers or below, most preferably of 20 nanometers or below.

The aperture size according to the present invention means the smallest diameter or free distance of a feature before plating, i.e. after seed deposition. The terms "aperture" and "opening" are used herein synonymously. A convex shape is a feature having an aperture size being at least 25 %, preferably 30 %, most preferably 50 % smaller than the biggest diameter or free distance of the feature before plating.

Typically, substrates are electroplated by contacting the substrate with the plating baths of the present invention. The substrate typically functions as the cathode. The plating bath contains an anode, which may be soluble or insoluble. Optionally, cathode and anode may be separated by a membrane. Potential is typically applied to the cathode. Sufficient current density is applied and plating performed for a period of time sufficient to deposit a metal layer, such as a copper layer, having a desired thickness on the substrate. Suitable current densities include, but are not limited to, the range of 0.5 to 250 mA/cm². Typically, the current density is in the range of 1 to 60 mA/cm² when used to deposit copper in the manufacture of integrated circuits. The specific current density depends on the substrate to be plated, the leveling agent selected and the like. Such current density choice is within the abilities of those skilled in the art. The applied current may be a direct current (DC), a pulse current (PC), a pulse reverse current (PRC) or other suitable current.

In general, when the present invention is used to deposit metal on a substrate such as a wafer used in the manufacture of an integrated circuit, the plating baths are agitated during use. Any suitable agitation method may be used with the present invention and such methods are well-known in the art. Suitable agitation methods include, but are not limited to, inert gas or air sparging, work piece agitation, impingement and the like.

Such methods are known to those skilled in the art. When the present invention is used to plate an integrated circuit substrate, such as a wafer, the wafer may be rotated such as from 1 to 150 RPM and the plating solution contacts the rotating wafer, such as by pumping or spraying. In the alternative, the wafer need not be rotated where the flow of the plating bath is sufficient to provide the desired metal deposit.

Copper is deposited in apertures according to the present invention without substantially forming voids within the metal copper deposit. By the term "without substantially forming voids", it is meant that 95% of the plated apertures are void-free. It is preferred that 98% of the plated apertures are void-free, mostly preferred is that all plated apertures are void-free.

Plating equipment for plating semiconductor substrates are well known. Plating equipment comprises an electroplating tank which holds Cu electrolyte and which is made of a suitable material such as plastic or other material inert to the electrolytic plating solution. The tank may be cylindrical, especially for wafer plating. A cathode is horizontally disposed at the upper part of tank and may be any type substrate such as a silicon wafer having openings such as trenches and vias. The wafer substrate is coated with a seed layer of cobalt. A cobalt seed layer may be applied by chemical vapor deposition (CVD), physical vapor deposition (PVD), atomic layer deposition (ALD) or the like. An anode is also preferably circular for wafer plating and is horizontally disposed at the lower part of tank forming a space between the anode and cathode. The anode is typically a soluble anode.

These bath additives are useful in combination with membrane technology being developed by various tool manufacturers. In this system, the anode may be isolated from the organic bath additives by a membrane. The purpose of the separation of the anode and the organic bath additives is to minimize the oxidation of the organic bath additives.

The cathode substrate and anode are electrically connected by wiring and, respectively, to a rectifier (power supply). The cathode substrate for direct or pulse current has a net negative charge so that Cu ions in the solution are reduced at the cathode substrate forming plated Cu metal on the cathode surface. An oxidation reaction takes place at the anode. The cathode and anode may be horizontally or vertically disposed in the tank.

Preferably the substrate comprises nanometer sized features and the deposition is performed to fill the micrometer or nanometer sized features, particularly those having an aperture size from 1 to 30 nm and/or an aspect ratio of 4 or more. The additives are even capable of void-free filling features having aperture sizes of 15 nm, particularly 10 nm or below and aspect ratios of 4 or more.

All percent, ppm or comparable values refer to the weight with respect to the total weight of the respective composition except where otherwise indicated.

The following examples shall further illustrate the present invention without restricting the scope of this invention.

### Analytical Methods

The molecular weight of the suppressing agents was determined by size-exclusion chromatography (SEC). Polystyrene was used as standard and tetrahydrofuran as eluent. The temperature of the column was 30°C, the injected volume 30 µL (µliter) and the flow rate 1.0 ml/min. The weight average molecular weight (M_{w}), the number average molecular weight (Mₙ) and the polydispersity PDI (M_{w}/Mₙ) of the suppressors were determined.

The amine number was determined according to DIN 53176 by titration of a solution of the polymer in acetic acid with perchloric acid.

### Examples

### Example A: Synthesis of Suppressors

Several suppressors have been synthesized by polyalkoxylation of the respective starters.

### Example A1: Synthesis of Suppressor 1

Diethylene triamine (154.8 g) was placed under nitrogen atmosphere into a 3.5 I autoclave and heated up to 100 °C. Then butylene oxide (540.9 g) was added over a period of 9 h. The mixture post-react for 10 h. A yellow intermediate product (653.9 g) having a hydroxy number of 604.5 mg KOH/g was obtained.

The intermediate product (463.8 g) and potassium tert-butoxide (1.6 g) were placed into a 3.5 I autoclave. After nitrogen neutralization, the pressure was adjusted to 1.5 bar and the mixture was homogenized at 130 °C for 1 h. Then butylene oxide (504.8 g) was added at 130 °C over a period of 8 h, reaching a maximum pressure of 5 bar. The mixture post-react for 6 h. Afterwards ethylene oxide (88.1 g) was added at 130 °C over a period of 2 h, reaching a maximum pressure of 5 bar. To complete the reaction, the mixture post-react for 6 h at 130 °C at a pressure of 7 bar. Then, the temperature was decreased to 80 °C and volatile compounds were removed in vacuum at 80 °C. Suppressor 1 was obtained as yellowish liquid (923.7 g) with a hydroxy value of 292.8 mg/g.

### Example A2: Synthesis of Suppressor 2

Diethylene triamine (253.8 g) was placed under nitrogen atmosphere into a 2 I autoclave and heated up to 100 °C. Then propylene oxide (714.0 g) was added over a period of 5.5 h. The mixture post-react for 10 h. A yellow intermediate product (962.0 g) having a hydroxy number of 700 mg KOH/g was obtained.

The intermediate product (120.9 g) and potassium tert-butoxide (1.5 g) were placed into a 2 I autoclave. After nitrogen neutralization, the pressure was adjusted to 1.5 bar and the mixture was homogenized at 130 °C for 1 h. Then propylene oxide (625.9 g) was added at 130 °C over a period of 11 h, reaching a maximum pressure of 5 bar. The mixture post-react for 10 h. Afterwards ethylene oxide (270.8 g) was added at 130 °C over a period of 4.5 h, reaching a maximum pressure of 5 bar. To complete the reaction, the mixture post-react for 6 h at 130 °C at a pressure of 5 bar. Then, the temperature was decreased to 80 °C and volatile compounds were removed in vacuum at 80 °C. Suppressor 2 was obtained as yellowish liquid (1048.7 g) with a hydroxy value of 84.5 mg KOH/g.

### Example A3: Synthesis of Suppressor 3

Diethylene triamine (253.8 g) was placed under nitrogen atmosphere into a 2 I autoclave and heated up to 100 °C. Then propylene oxide (714.0 g) was added over a period of 5.5 h. The mixture post-react for 10 h. A yellow intermediate product (962.0 g) having a hydroxy number of 700 mg KOH/g was obtained.

The intermediate product (137.8 g) and potassium tert-butoxide (0.9 g) were placed into a 3.5 I autoclave. After nitrogen neutralization, the pressure was adjusted to 1.5 bar and the mixture was homogenized at 130 °C for 1 h. Then propylene oxide (304.9g) was added at 130 °C over a period of 5 h, reaching a maximum pressure of 5 bar. The mixture post-react for 6 h. Afterwards ethylene oxide (154.2 g) was added at 130 °C over a period of 3 h, reaching a maximum pressure of 5 bar. To complete the reaction, the mixture post-react for 6 h at 130 °C at a pressure of 5 bar. Then, the temperature was decreased to 80 °C and volatile compounds were removed in vacuum at 80 °C. Suppressor 3 was obtained as yellowish liquid (568.9 g) with a hydroxy value of 170.0 mg KOH/g.

### Example A4: Synthesis of Suppressor 4

Diethylene triamine (253.8 g) was placed under nitrogen atmosphere into a 2 I autoclave and heated up to 100 °C. Then propylene oxide (714.0 g) was added over a period of 5.5 h. The mixture post-react for 10 h. A yellow intermediate product (962.0 g) having a hydroxy number of 700 mg KOH/g was obtained.

The intermediate product (236.1 g) and potassium tert-butoxide (1.4 g) were placed into a 3.5 I autoclave. After nitrogen neutralization, the pressure was adjusted to 1.5 bar and the mixture was homogenized at 130 °C for 1 h. Then propylene oxide (592.4 g) was added at 130 °C over a period of 10 h, reaching a maximum pressure of 5 bar. The mixture post-react for 6 h. Afterwards ethylene oxide (79.3 g) was added at 130 °C over a period of 2 h, reaching a maximum pressure of 5 bar. To complete the reaction, the mixture post-react for 6 h at 130 °C at a pressure of 5 bar. Then, the temperature was decreased to 80 °C and volatile compounds were removed in vacuum at 80 °C. Suppressor 4 was obtained as yellowish liquid (887.6 g) with a hydroxy value of 180.4 mg KOH/g.

### Example A5: Synthesis of Suppressor 5

Diethylene triamine (253.8 g) was placed under nitrogen atmosphere into a 2 I autoclave and heated up to 100 °C. Then propylene oxide (714.0 g) was added over a period of 5.5 h. The mixture post-react for 10 h. A yellow intermediate product (962.0 g) having a hydroxy number of 700 mg KOH/g was obtained.

The intermediate product (157.4 g) and potassium tert-butoxide (0.9 g) were placed into a 3.5 I autoclave. After nitrogen neutralization, the pressure was adjusted to 1.5 bar and the mixture was homogenized at 130 °C for 1 h. Then propylene oxide (348.5 g) was added at 130 °C over a period of 6 h, reaching a maximum pressure of 5 bar. The mixture post-react for 6 h. Afterwards ethylene oxide (114.5 g) was added at 130 °C over a period of 2 h, reaching a maximum pressure of 5 bar. To complete the reaction, the mixture post-react for 6 h at 130 °C at a pressure of 5 bar. Then, the temperature was decreased to 80 °C and volatile compounds were removed in vacuum at 80 °C. Surfactant 5 was obtained as yellowish liquid (598.6 g) with a hydroxy value of 182.4 mg KOH/g.

### Example B: Copper electroplating experiments

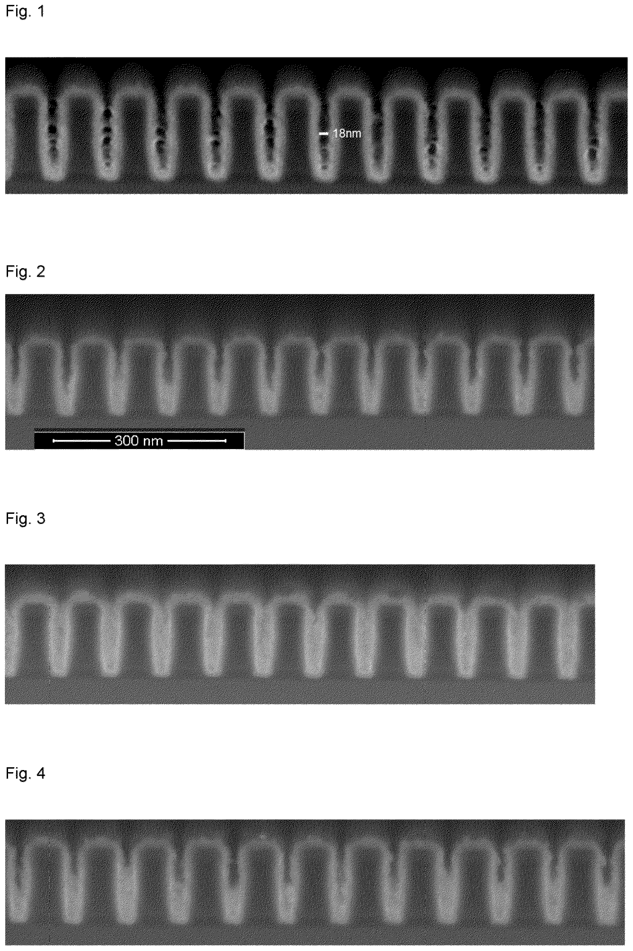

For the plating experiments a patterned wafer substrate was used as shown in Fig.1. The wafer substrate was bearing a 50 A CVD Co seed on a 30 A TaN layer and having features with a diameter of 15 nm at the top of the opening, a diameter of 18 nm at half height of the feature and a diameter of 11 nm at the bottom of the feature. The feature height was about 136 nm which results in an aspect ratio of about 7.5.

### Example B1a: Electroplating with suppressor 1, partial fill

A plating bath was prepared by combining DI water, 0.5 g/l copper as copper sulfate, 2.5 g/l sulfuric acid, 0.050 g/l chloride ion as HCl, 0.040 g/l bromide ion as HBr, 0.081 g/l of SPS and 3.43 ml/l of a 1.8wt% solution in DI water of suppressor 1 as prepared in example A1.

A copper layer was electroplated onto a wafer substrate with features provided with a cobalt seed layer by contacting the wafer substrate with the above described plating bath at 18 °C applying a direct current of -1.01 mA/cm² for 29.0 s. The thus electroplated copper layer was investigated by SEM inspection.

The result is shown in Fig. 2 which provides the SEM image of the trenches partially filled with copper. Fig. 2 shows that the copper is deposited on the bottom of the feature while the deposition on the side walls of the feature is suppressed.

### Example B1b: Electroplating with suppressor 1, full fill

A plating bath was prepared by combining DI water, 0.5 g/l copper as copper sulfate, 2.5 g/l sulfuric acid, 0.050 g/l chloride ion as HCl, 0.040 g/l bromide ion as HBr, 0.081 g/l of SPS and 3.43 ml/l of a 1.8 wt % solution in DI water of suppressor 1 as prepared in example A1.

A copper layer was electroplated onto a wafer substrate with features provided with a cobalt seed layer by contacting the wafer substrate with the above described plating bath at 18 °C applying a direct current of -1.01 mA/cm² for 65.4 s. The thus electroplated copper layer was investigated by SEM inspection.

The result is shown in Fig. 3 which provides the SEM image of the copper filled trenches. The neighboring trenches are equally filled without exhibiting significant voids or seams in the fully filled trenches as shown in Fig. 3.

### Example B1c: Electroplating with suppressor 1, partial fill with leveler

A plating bath was prepared by combining DI water, 0.5 g/l copper as copper sulfate, 2.5 g/l sulfuric acid, 0.050 g/l chloride ion as HCl, 0.040 g/l bromide ion as HBr, 0.081 g/l of SPS, 0.5 ml/l of a 0.866 wt% solution in DI water of a polyalkanolamine type leveler and 3.43 ml/l of a 1.8wt% solution in DI water of suppressor 1 as prepared in example A1.

A copper layer was electroplated onto a wafer substrate with features provided with a cobalt seed layer by contacting the wafer substrate with the above described plating bath at 18 °C applying a direct current of -1.01 mA/cm² for 29.0 s. The thus electroplated copper layer was investigated by SEM inspection.

The result is shown in Fig. 4 which provides the SEM image of the trenches partially filled with copper. Fig. 4 shows a pronounced bottom-up-growth of the copper in the features.

### Example B1d: Electroplating with suppressor 1, full fill with leveler

A plating bath was prepared by combining DI water, 0.5 g/l copper as copper sulfate, 2.5 g/l sulfuric acid, 0.050 g/l chloride ion as HCl, 0.040 g/l bromide ion as HBr, 0.081 g/l of SPS, 0.5 ml/l of a 0.866 wt% solution in DI water of a polyalkanolamine type leveler and 3.43 ml/l of a 1.8 wt% solution in DI water of suppressor 1 as prepared in example A1.

A copper layer was electroplated onto a wafer substrate with features provided with a cobalt seed layer by contacting the wafer substrate with the above described plating bath at 18 °C applying a direct current of -1.01 mA/cm² for 65.4 s. The thus electroplated copper layer was investigated by SEM inspection.

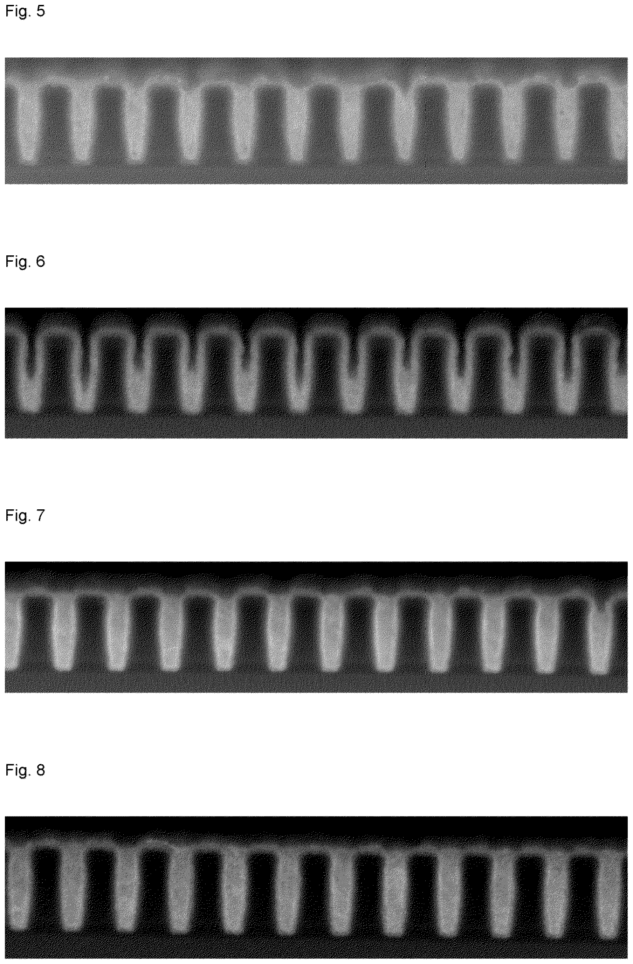

The result is shown in Fig. 5 which provides the SEM image of the copper filled trenches. The neighboring trenches are equally filled without exhibiting significant voids or seams in the fully filled trenches as shown in Fig. 5.

### Example B2a: Electroplating with suppressor 2, partial fill

A plating bath was prepared by combining DI water, 0.5 g/l copper as copper sulfate, 2.5 g/l sulfuric acid, 0.050 g/l chloride ion as HCl, 0.040 g/l bromide ion as HBr, 0.081 g/l of SPS, 0.5 ml/l of a 0.866 wt% solution in DI water of a polyalkanolamine type leveler and 37.0 ml/l of a 1.8 wt% solution in DI water of suppressor 2 as prepared in example A2.

A copper layer was electroplated onto a wafer substrate with features provided with a cobalt seed layer by contacting the wafer substrate with the above described plating bath at 18 °C applying a direct current of -1.01 mA/cm² for 29.0 s. The thus electroplated copper layer was investigated by SEM inspection.

The result is shown in Fig. 6 which provides the SEM image of the copper filled trenches. The neighboring trenches are equally filled without exhibiting voids or seams in the partially filled trenches as shown in Fig. 6.

### Example B2b: Electroplating with suppressor 2, full fill

A plating bath was prepared by combining DI water, 0.5 g/l copper as copper sulfate, 2.5 g/l sulfuric acid, 0.050 g/l chloride ion as HCl, 0.040 g/l bromide ion as HBr, 0.081 g/l of SPS, 0.5 ml/l of a 0.866 wt% solution in DI water of a polyalkanolamine type leveler and 37.0 ml/l of a 1.8 wt% solution in DI water of suppressor 2 as prepared in example A2.

A copper layer was electroplated onto a wafer substrate with features provided with a cobalt seed layer by contacting the wafer substrate with the above described plating bath at 18 degrees C applying a direct current of -1.01 mA/cm² for 43.5 s. The thus electroplated copper layer was investigated by SEM inspection.

The result is shown in Fig. 7 which provides the SEM image of the copper filled trenches. The neighboring trenches are equally filled without exhibiting voids or seams in the fully filled trenches as shown in Fig. 7.

### Example B2c: Electroplating with Suppressor 2, full fill

A plating bath was prepared by combining DI water, 0.5 g/l copper as copper sulfate, 2.5 g/l sulfuric acid, 0.050 g/l chloride ion as HCl, 0.080 g/l bromide ion as HBr, 0.081 g/l of SPS, 0.5 ml/l of a 0.866 wt% solution in DI water of a polyalkanolamine type leveler and 37.0 ml/l of a 1.8wt % solution in DI water of suppressor 2 as prepared in example A2.

A copper layer was electroplated onto a wafer substrate with features provided with a cobalt seed layer by contacting the wafer substrate with the above described plating bath at 18 degrees C applying a direct current of -1.01 mA/cm² for 65.4 s. The thus electroplated copper layer was investigated by SEM inspection.

The result is shown in Fig. 8 which provides the SEM image of the copper filled trenches. The neighboring trenches are equally filled without exhibiting voids or seams in the fully filled trenches as shown in Fig. 8.

### Example B3a: Electroplating with suppressor 3, partial fill

A plating bath was prepared by combining DI water, 0.5 g/l copper as copper sulfate, 2.5 g/l sulfuric acid, 0.050 g/l chloride ion as HCl, 0.040 g/l bromide ion as HBr, 0.081 g/l of SPS, 0.5 ml/l of a 0.866 wt% solution in DI water of a polyalkanolamine type leveler and 19.0 ml/l of a 1.8 wt% solution in DI water of suppressor 3 as prepared in example A3.

A copper layer was electroplated onto a wafer substrate with features provided with a cobalt seed layer by contacting the wafer substrate with the above described plating bath at 18 degrees C applying a direct current of -1.01 mA/cm² for 21.8 s. The thus electroplated copper layer was investigated by SEM inspection.

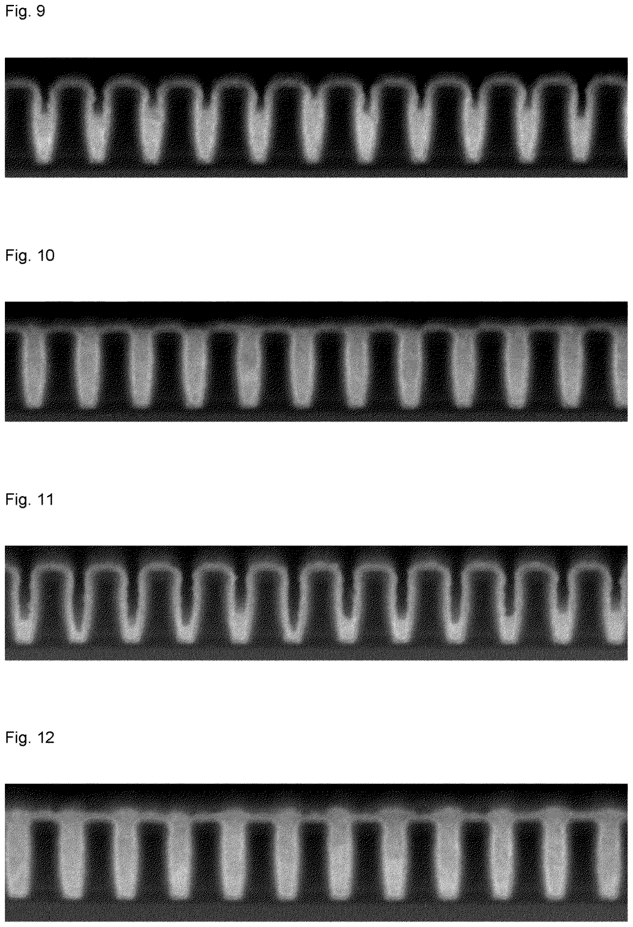

The result is shown in Fig. 9 which provides the SEM image of the copper filled trenches. The neighboring trenches are equally filled without exhibiting voids or seams in the partially filled trenches as shown in Fig. 9.

### Example B3b: Electroplating with suppressor 3, full fill

A plating bath was prepared by combining DI water, 0.5 g/l copper as copper sulfate, 2.5 g/l sulfuric acid, 0.050 g/l chloride ion as HCl, 0.040 g/l bromide ion as HBr, 0.081 g/l of SPS, 0.5 ml/l of a 0.866 wt% solution in DI water of a polyalkanolamine type leveler and 19.0 ml/l of a 1.8 wt% solution in DI water of suppressor 3 as prepared in example A3.

A copper layer was electroplated onto a wafer substrate with features provided with a cobalt seed layer by contacting the wafer substrate with the above described plating bath at 18 degrees C applying a direct current of -1.01 mA/cm² for 43.6 s. The thus electroplated copper layer was investigated by SEM inspection.

The result is shown in Fig. 10 which provides the SEM image of the copper filled trenches. The neighboring trenches are equally filled without exhibiting voids or seams in the fully filled trenches as shown in Fig. 10.

### Example B4a: Electroplating with Suppressor 4, partial fill

A plating bath was prepared by combining DI water, 0.5 g/l copper as copper sulfate, 2.5 g/l sulfuric acid, 0.050 g/l chloride ion as HCl, 0.040 g/l bromide ion as HBr, 0.081 g/l of SPS, 0.5 ml/l of a 0.866 wt% solution in DI water of a polyalkanolamine type leveler and 19.0 ml/l of a 1.8 wt% solution in DI water of suppressor 4 as prepared in example A4.

A copper layer was electroplated onto a wafer substrate with features provided with a cobalt seed layer by contacting the wafer substrate with the above described plating bath at 18 degrees C applying a direct current of -1.01 mA/cm² for 21.8 s. The thus electroplated copper layer was investigated by SEM inspection.

The result is shown in Fig. 11 which provides the SEM image of the copper filled trenches. The neighboring trenches are equally filled without exhibiting voids or seams in the partially filled trenches as shown in Fig. 11.

### Example B4b: Electroplating with Suppressor 4, full fill

A plating bath was prepared by combining DI water, 0.5 g/l copper as copper sulfate, 2.5 g/l sulfuric acid, 0.050 g/l chloride ion as HCl, 0.040 g/l bromide ion as HBr, 0.081 g/l of SPS, 0.5 ml/l of a 0.866 wt% solution in DI water of a polyalkanolamine type leveler and 19.0 ml/l of a 1.8 wt% solution in DI water of suppressor 4 as prepared in example A4.

A copper layer was electroplated onto a wafer substrate with features provided with a cobalt seed layer by contacting the wafer substrate with the above described plating bath at 18 degrees C applying a direct current of -1.01 mA/cm² for 65.4 s. The thus electroplated copper layer was investigated by SEM inspection.

The result is shown in Fig. 12 which provides the SEM image of the copper filled trenches. The neighboring trenches are equally filled without exhibiting voids or seams in the fully filled trenches as shown in Fig. 12.

### Example B5a: Electroplating with Suppressor 5, partial fill

A plating bath was prepared by combining DI water, 0.5 g/l copper as copper sulfate, 2.5 g/l sulfuric acid, 0.050 g/l chloride ion as HCl, 0.040 g/l bromide ion as HBr, 0.081 g/l of SPS, 0.5 ml/l of a 0.866 wt% solution in DI water of a polyalkanolamine type leveler and 19.0 ml/l of a 1.8 wt% solution in DI water of suppressor 5 as prepared in example A5.

A copper layer was electroplated onto a wafer substrate with features provided with a cobalt seed layer by contacting the wafer substrate with the above described plating bath at 18 degrees C applying a direct current of -1.01 mA/cm² for 21.8 s. The thus electroplated copper layer was investigated by SEM inspection.

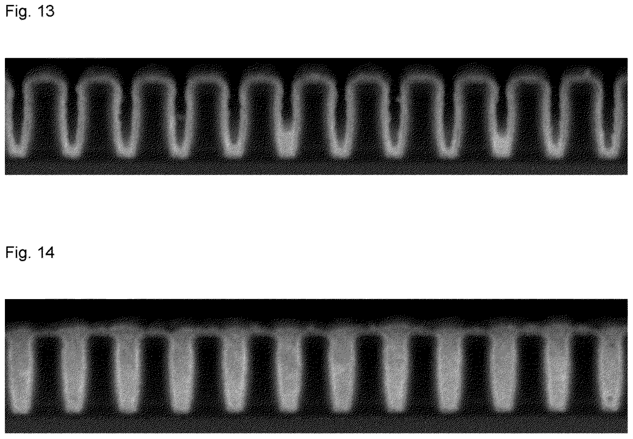

The result is shown in Fig. 13 which provides the SEM image of the copper filled trenches. The neighboring trenches are equally filled without exhibiting voids or seams in the partially filled trenches as shown in Fig. 13.

### Example B5b: Electroplating with Suppressor 5, full fill

A plating bath was prepared by combining DI water, 0.5 g/l copper as copper sulfate, 2.5 g/l sulfuric acid, 0.050 g/l chloride ion as HCl, 0.040 g/l bromide ion as HBr, 0.081 g/l of SPS, 0.5 ml/l of a 0.866 wt% solution in DI water of a polyalkanolamine type leveler and 19.0 ml/l of a 1.8 wt % solution in DI water of suppressor 5 as prepared in example A5.

A copper layer was electroplated onto a wafer substrate with features provided with a cobalt seed layer by contacting the wafer substrate with the above described plating bath at 18 degrees C applying a direct current of -1.01 mA/cm² for 65.4 s. The thus electroplated copper layer was investigated by SEM inspection.

The result is shown in Fig. 14 which provides the SEM image of the copper filled trenches. The neighboring trenches are equally filled without exhibiting significant voids or seams in the fully filled trenches as shown in Fig. 14.

### Example C: Co corrosion experiments

A blanket wafer substrate seeded with 40 nm Co was immersed in an aqueous solution containing 0.05 wt% citric acid for 30 s at room temperature to remove Co oxide. The substrate was removed from the solution and rinsed with DI water and blow-dried. Before and after the treatment with citric acid the thickness of the Co layer has been measured by XRF. The citric-acid-cleaning procedure has been conducted on ten wafer coupons to give an average reduction of Co layer thickness by 2 nm.

For the Co corrosion experiment the precleaned wafer substrate was immersed in an aqueous solution containing 0.5 g/l Cu as copper sulfate, 2.5 g/l sulfuric acid, 0.050 g/l chloride ion as HCl, 0.080 g/l bromide ion as HBr and 270 ppm of the suppressors prepared in example A for 60 s at 25 °C. The substrate was removed from the solution and rinsed with DI water and blow-dried. The thickness of the Co layer was measured by XRF before the precleaning and after the corrosion experiment. The obtained change of Co layer thickness was corrected by 2 nm due to the oxide removal by precleaning the substrate with citric acid. Each corrosion experiment was repeated twice and the results were averaged.

The results of the Co corrosion experiments are shown in Table 1 as change of the Co thickness (ΔTHK(Co). Negative numbers indicate a reduction of the Co layer thickness. The suppressors of the invention clearly show an inhibiting effect on the Co corrosion by only small changes of the Co layer thickness. Without any suppressor in the electrolyte solution the Co layer thickness is reduced by about 24 nm. By adding suppressors of the invention the Co layer thickness is reduced to only about 4 nm or less in the static corrosion experiment.

**Table 1**

| Suppressor No. | Starter | EO per starter | PO or BuO per starter | Arrangement | M_{W} [g/mol] | ΔTHK(Co) [nm] |
|---|---|---|---|---|---|---|
| n/a | - | - | - | - | - | -24.1 |
| 1 | Diethylene triamine | 2 | 12 BuO | -BuO-EO block | 1056 | 0.5* |
| 2 | Diethylene triamine | 20 | 40 PO | -PO-EO block | 3303 | -3.7 |
| 3 | Diethylene triamine | 10 | 20 PO | -PO-EO block | 1705 | -1.4 |
| 4 | Diethylene triamine | 3 | 22 PO | -PO-EO block | 1512 | -1.1 |
| 5 | Diethylene triamine | 6.5 | 20 PO | -PO-EO block | 1549 | -2.4 |

| | | | | | | |
|---|---|---|---|---|---|---|
| * means no loss within the tolerance | | | | | | |

Table 1 shows that by adding the respective additives, the reduction of cobalt layer thickness by static cobalt corrosion is strongly inhibited. The tolerances in the measurement of the cobalt thickness was about 0.4-0.5 nm.

## Claims

1. An acidic aqueous composition for copper electroplating comprising
(a) copper ions;
(b) bromide ions; and
(c) at least one additive of formula S1 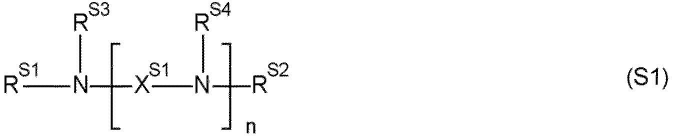 wherein
X^{S1} is selected from a linear, branched or cyclic C₁-C₁₂ alkanediyl, which may be substituted or unsubstituted, and which may optionally be interrupted by O, S or NR^{S40};
R^{S1} is a monovalent
(a) poly(oxy(C₃ to C₆ )alkylene)-block-poly(oxyethylene) group which is bound to the N-atom by the poly(oxy(C₃ to C₆ )alkylene part, or
(b) a poly(oxyethylene)-block-poly(oxy(C₃ to C₆ )alkylene)-block-poly(oxyethylene),
which groups both have a poly(oxyethylene) content of from 5 to 30 % by weight;
R^{S2}, R^{S3}, R^{S4} are
(a) selected from H, R^{S1}, R^{S40}, or
(b) R^{S3} and an adjacent group R^{S4} or, if n>2, two adjacent groups R^{S4} may together form a divalent group X^{S3};
R^{S40} is selected from (a) linear or branched C₁-C₂₀ alkyl, which may optionally be substituted by hydroxyl, alkoxy or alkoxycarbonyl, and (b) linear or branched C₁-C₂₀ alkenyl, which may optionally be substituted by hydroxyl, alkoxy or alkoxycarbonyl;
X^{S3} is selected from a linear, branched or cyclic C₁-C₁₂ alkanediyl, which may be substituted or unsubstituted, and which may optionally be interrupted by O, S or NR^{S40}; and
n is an integer of from 1 to 6.

2. The composition according to claim 1, wherein X^{S1} is selected from (a) a C₁-C₆ alkanediyl, preferably methanediyl, ethanediyl or propanediyl, and (b) -(CH₂)_{q}-[Q-(CH₂)ᵣ]ₛ-, wherein Q is selected from O, S or NR⁴⁰, q and r are integers from 1 to 6, s is an integer from 1 to 4 and q + r s is the total number of C atoms in X^{S1}.

3. The composition according to anyone of the preceding claims, wherein the mass average molecular mass of the additive is from 300 to 6 000 g/mol, preferably from 1 000 to 4 000 g/mol.

4. The composition according to anyone of the preceding claims, wherein
n is 1, 2, or 3; and
R^{S2}, R^{S3}, R^{S4} are independently selected from R^{S1}.

5. The composition according to anyone of the preceding claims, wherein R^{S1} is a monovalent poly(oxypropylene)-block-poly(oxyethylene) group.

6. The composition according to claim 5, wherein the poly(oxyethylene) content of R^{S1} is from 8 to 28 % by weight.

7. The composition according to anyone of the preceding claims, wherein R^{S1} is a monovalent poly(oxybutylene)-block-poly(oxyethylene) group.

8. The composition according to claim 7, wherein the poly(oxyethylene) content of R^{S1} is from 8 to 28 % by weight

9. The composition according to anyone of the preceding claims, comprising an additive of formula (S2a) 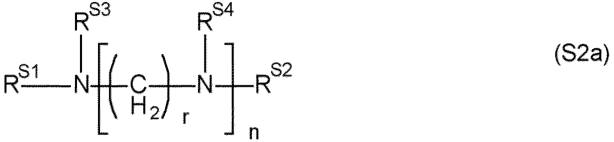 or an additive of formula (S2b) 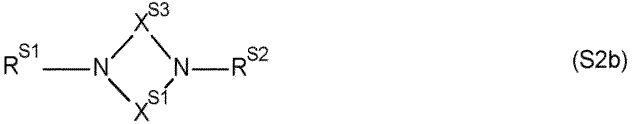 or an additive of formula (S2c) 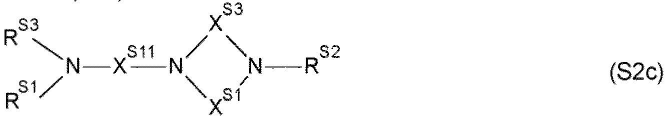 or an additive of formula (S2d) 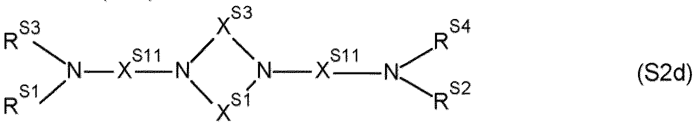 wherein
R^{S1}, n, have the prescribed meanings;
R^{S2}, R^{S3} and R^{S4} are independently R^{S1} or R^{S40}, preferably R^{S1};
X^{S1}, X^{S11}, X^{S3} are independently C₁ to C₃ alkanediyl; and
r is an integer from 1 to 8, preferably from 2 to 6.

10. The composition according to anyone of the preceding claims, wherein the bromide ions are present in a concentration of from 5 to 100 ppm, preferably from 20 to 80 ppm.

11. The composition according to anyone of the preceding claims, further comprising chloride ions in a concentration of from 10 to 100 ppm, preferably from 20 to 80 ppm.

12. Use of a copper electroplating bath comprising a composition according to anyone of claims 1 to 11 for depositing copper on substrates comprising recessed features having an aperture size of 10 nanometers or less, preferably 5 nm or less, which features comprise a cobalt seed layer.

13. A process for depositing a copper layer comprising the steps
(a) providing a substrate comprising a nanometer-sized recessed feature, which feature comprises a cobalt seed layer;
(b) contacting a composition according to any one of claims 1 to 11 with the substrate, and
(c) applying a current to the substrate for a time sufficient to deposit a metal layer onto the cobalt seed layer and to fill the nanometer sized feature.

## Patentansprüche

1. Saure wässrige Zusammensetzung für die galvanische Abscheidung von Kupfer, umfassend
(a) Kupferionen;
(b) Bromidionen; und
(c) mindestens ein Additiv der Formel S1 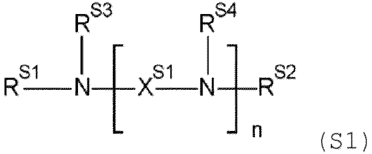 wobei
X^{S1} aus einem linearen, verzweigten oder cyclischen C₁-C₁₂-Alkandiyl, das substituiert oder unsubstituiert sein kann und das gegebenenfalls durch O, S oder NR^{S40} unterbrochen sein kann, ausgewählt ist;
R^{S1} für eine einwertige
(a) Poly(oxy(C₃- bis C₆)-alkylen)-block-poly(oxyethylen)-Gruppe, die über den Poly(oxy(C₃- bis C₆)-Alkylenteil an das N-Atom gebunden ist, oder
(b) eine Poly(oxyethylen)-block-poly(oxy(C₃- bis C₆)-alkylen)-block-poly(oxyethylen)-Gruppe
steht, wobei beide Gruppen einen Poly(oxyethylen)-Gehalt von 5 bis 30 Gew.-% aufweisen;
R^{S2}, R^{S3} und R^{S4}
(a) aus H, R^{S1} und R^{S40} ausgewählt sind oder
(b) R^{S3} und eine benachbarte Gruppe R^{S4} oder im Fall von n>2 zwei benachbarte Gruppen R^{S4} zusammen eine zweiwertige Gruppe X^{S3} bilden können;
R^{S40} aus (a) linearem oder verzweigtem C₁-C₂₀-Alkyl, das gegebenenfalls durch Hydroxyl, Alkoxy oder Alkoxycarbonyl substituiert sein kann, und (b) linearem oder verzweigtem C₁-C₂₀-Alkenyl, das gegebenenfalls durch Hydroxyl, Alkoxy oder Alkoxycarbonyl substituiert sein kann, ausgewählt ist;
X^{S3} aus einem linearen, verzweigten oder cyclischen C₁-C₁₂-Alkandiyl, das substituiert oder unsubstituiert sein kann und das gegebenenfalls durch O, S oder NR^{S40} unterbrochen sein kann, ausgewählt ist; und
n für eine ganze Zahl von 1 bis 6 steht.

2. Zusammensetzung nach Anspruch 1, wobei X^{S1} aus (a) einem C₁-C₆-Alkandiyl, vorzugsweise Methandiyl, Ethandiyl oder Propandiyl, und (b) -(CH₂)_{q}-[Q-(CH₂)ᵣ]ₛ-, wobei Q aus O, S oder NR⁴⁰ ausgewählt ist, q und r für ganze Zahl von 1 bis 6 stehen, s für eine ganze Zahl von 1 bis 4 steht und q + r s die Gesamtzahl von C-Atomen in X^{S1} ist, ausgewählt ist.

3. Zusammensetzung nach einem der vorhergehenden Ansprüche, wobei die massenmittlere Molmasse des Additivs 300 bis 6000 g/mol, vorzugsweise 1000 bis 4000 g/mol, beträgt.

4. Zusammensetzung nach einem der vorhergehenden Ansprüche, wobei
n für 1, 2 oder 3 steht; und
R^{S2}, R^{S3} und R^{S4} unabhängig aus R^{S1} ausgewählt sind.

5. Zusammensetzung nach einem der vorhergehenden Ansprüche, wobei R^{S1} für eine einwertige Poly(oxypropylen)-block-poly(oxyethylen)-Gruppe steht.

6. Zusammensetzung nach Anspruch 5, wobei der Poly(oxyethylen)-Gehalt von R^{S1} 8 bis 28 Gew.-% beträgt.

7. Zusammensetzung nach einem der vorhergehenden Ansprüche, wobei R^{S1} für eine einwertige Poly(oxybutylen)-block-poly(oxyethylen)-Gruppe steht.

8. Zusammensetzung nach Anspruch 7, wobei der Poly(oxyethylen)-Gehalt von R^{S1} 8 bis 28 Gew.-% beträgt.

9. Zusammensetzung nach einem der vorhergehenden Ansprüche, umfassend ein Additiv der Formel (S2a) 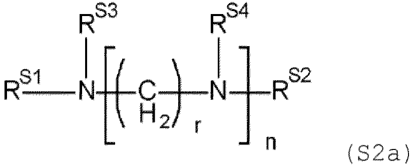 oder ein Additiv der Formel (S2b) 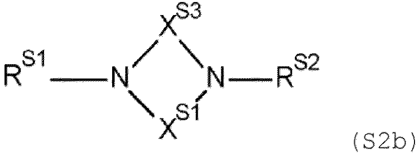 oder ein Additiv der Formel (S2c) 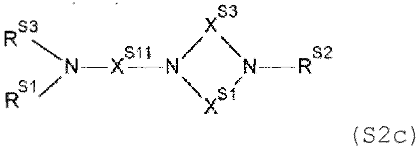 oder ein Additiv der Formel (S2d) 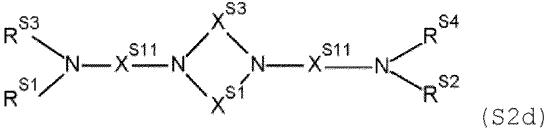 wobei
R^{S1} und n die vorgeschriebenen Bedeutungen haben;
R^{S2}, R^{S3} und R^{S4} unabhängig für R^{S1} oder R^{S40}, vorzugsweise ^{S1}, stehen;
X^{S1}, X^{S11} und X^{S3} unabhängig für C₁- bis C₃-Alkandiyl stehen; und
r für eine ganze Zahl von 1 bis 8, vorzugsweise von 2 bis 6, steht.

10. Zusammensetzung nach einem der vorhergehenden Ansprüche, wobei die Bromidionen in einer Konzentration von 5 bis 100 ppm, vorzugsweise von 20 bis 80 ppm, vorliegen.

11. Zusammensetzung nach einem der vorhergehenden Ansprüche, ferner umfassend Chloridionen in einer Konzentration von 10 bis 100 ppm, vorzugsweise von 20 bis 80 ppm.

12. Verwendung eines Bads für die galvanische Abscheidung von Kupfer, umfassend eine Zusammensetzung nach einem der Ansprüche 1 bis 11, zum Abscheiden von Kupfer auf Substraten mit vertieften Strukturmerkmalen mit einer Aperturgröße von 10 Nanometer oder weniger, vorzugsweise 5 nm oder weniger, wobei die Strukturmerkmale eine Cobaltkeimschicht umfassen.

13. Verfahren zum Abscheiden einer Kupferschicht, das folgende Schritte umfasst:
(a) Bereitstellen eines Substrats mit einem nanometergroßen vertieften Strukturmerkmal, wobei das Strukturmerkmal eine Cobaltkeimschicht umfasst;
(b) Inberührungbringen einer Zusammensetzung nach einem der Ansprüche 1 bis 11 mit dem Substrat und
(c) Anlegen eines Stroms an das Substrat über einen zur Abscheidung einer Metallschicht auf der Cobaltkeimschicht und zum Füllen des nanometergroßen Strukturmerkmals ausreichenden Zeitraum.

## Revendications

1. Composition aqueuse acide pour cuivrage électrolytique comprenant
(a) des ions cuivre ;
(b) des ions bromure ; et
au moins un additif de formule S1 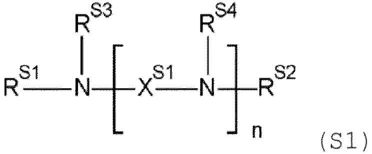
dans laquelle
X^{S1} est choisi parmi un alcanediyle en C₁-C₁₂ linéaire, ramifié ou cyclique, qui peut être substitué ou non substitué, et qui peut éventuellement être interrompu par O, S ou NR^{S40} ;
R^{S1} est un groupe monovalent
poly(oxy(alkylène en C₃ à C₆))-bloc-poly(oxyéthylène) qui est lié à l'atome N par la partie poly(oxy(alkylène en C₃ à C₆), ou
poly(oxyéthylène)-bloc-poly(oxy(alkylène en C₃ à C₆))-bloc-poly(oxyéthylène),
lesdits groupes ayant tous deux une teneur en poly(oxyéthylène) de 5 à 30 % en poids ;
R^{S2}, R^{S3}, R^{S4} sont
(a) choisis parmi H, R^{S1}, R^{S40}, ou
(b) R^{S3} et un groupe R^{S4} adjacent ou, si n > 2, deux groupes R^{S4} adjacents peuvent former conjointement un groupe X^{S3} divalent ;
R^{S40} est choisi parmi (a) un alkyle en C₁-C₂₀ linéaire ou ramifié, qui peut éventuellement être substitué par hydroxyle, alcoxy ou alcoxycarbonyle, et (b) un alcényle en C₁-C₂₀ linéaire ou ramifié, qui peut éventuellement substitué par hydroxyle, alcoxy ou alcoxycarbonyle ;
X^{S3} est choisi parmi un alcanediyle en C₁-C₁₂ linéaire, ramifié ou cyclique, qui peut être substitué ou non substitué, et qui peut éventuellement être interrompu par O, S ou NR^{S40} ; et
n est un entier de 1 à 6 ;

2. Composition selon la revendication 1, dans laquelle X^{S1} est choisi parmi (a) un alcanediyle en C₁-C₆, de préférence méthanediyle, éthanediyle ou propanediyle, et (b) -(CH₂)_{q}-[Q-(CH₂)ᵣ]ₛ-, dans lequel Q est choisi parmi O, S ou NR⁴⁰, q et r sont des entiers de 1 à 6, s est un entier de 1 à 4 et q + r s est le nombre total d'atomes C dans X^{S1}.

3. Composition selon l'une quelconque des revendications précédentes, dans laquelle la masse moléculaire moyenne en masse de l'additif est de 300 à 6 000 g/mol, de préférence de 1 000 à 4 000 g/mol.

4. Composition selon l'une quelconque des revendications précédentes, dans laquelle n est 1, 2 ou 3 ; et
R^{S2}, R^{S3}, R^{S4} sont indépendamment choisis parmi R^{S1}.

5. Composition selon l'une quelconque des revendications précédentes, dans laquelle R^{S1} est un groupe poly(oxypropylène)-bloc-poly(oxyéthylène) monovalent.

6. Composition selon la revendication 5, dans laquelle la teneur en poly(oxyéthylène) de R^{S1} est de 8 à 28 % en poids.

7. Composition selon l'une quelconque des revendications précédentes, dans laquelle R^{S1} est un groupe poly(oxypropylène)-bloc-poly(oxyéthylène) monovalent.

8. Composition selon la revendication 7, dans laquelle la teneur en poly(oxyéthylène) de R^{S1} est de 8 à 28 % en poids.

9. Composition selon l'une quelconque des revendications précédentes, comprenant un additif de formule (S2a) 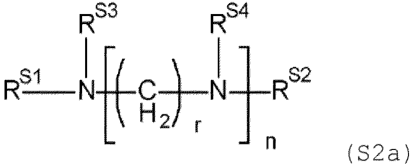 ou un additif de formule (S2b) 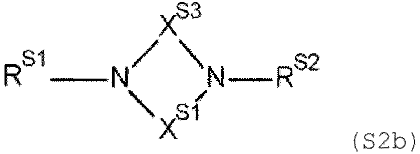 ou un additif de formule (S2c) 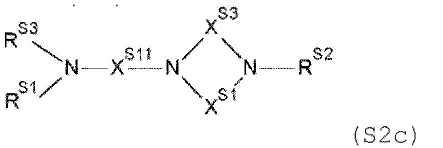 ou un additif de formule (S2d) 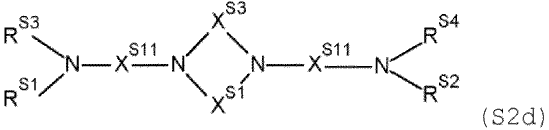 dans lequel
R^{S1}, n, ont les significations prescrites ;
R^{S2}, R^{S3} et R^{S4} sont indépendamment R^{S1} ou R^{S40}, de préférence R^{S1} ;
X^{S1}, X^{S11}, X^{S3} sont indépendamment alcanediyle en C₁ à C₃ ; et
r est un entier de 1 à 8, préférablement de 2 à 6.

10. Composition selon l'une quelconque des revendications précédentes, dans laquelle les ions bromure sont présents à une concentration de 5 à 100 ppm, de préférence de 20 à 80 ppm.

11. Composition selon l'une quelconque des revendications précédentes, comprenant en outre des ions chlorure à une concentration de 10 à 100 ppm, de préférence de 20 à 80 ppm.

12. Utilisation d'un bain de cuivrage électrolytique comprenant une composition selon l'une quelconque des revendications 1 à 11 pour déposer du cuivre sur des substrats comprenant des éléments évidés ayant une taille d'ouverture inférieure ou égale à 10 nanomètres, de préférence de 5 nm ou moins, lesdits éléments comprenant une couche de germe de cobalt.

13. Procédé de dépôt d'une couche de cuivre comprenant les étapes de
(a) fourniture d'un substrat comprenant un élément évidé de taille nanométrique, ledit élément comprenant une couche de'germe de cobalt ;
b) mise en contact d'une composition selon l'une quelconque des revendications 1 à 11 avec le substrat, et
application d'un courant au substrat pendant une durée suffisante pour déposer une couche métallique sur la couche de germe de cobalt et pour remplir l'élément de taille nanométrique.
